# EUROPEAN PATENT SPECIFICATION

(11) **EP 3 947 901 B1**
(45) Date of publication and mention of the grant of the patent: **05.03.2025**
(21) Application number: 20779794.5
(22) Date of filing: 24.03.2020
(51) Int. Cl.: E21B 41/00, E21B 47/12, G01V 1/50

(54) **SECONDARY RECOVERY SURVEILLANCE USING VALIDATED STREAMLINE-BASED SIMULATION**
ÜBERWACHUNG DER SEKUNDÄREN RÜCKGEWINNUNG UNTER VERWENDUNG VALIDIERTER STROMLINIENBASIERTER SIMULATION
SURVEILLANCE DE RÉCUPÉRATION SECONDAIRE À L'AIDE D'UNE SIMULATION BASÉE SUR UNE RATIONALISATION VALIDÉE

(30) Priority: 26.03.2019 IN 201911011813
(43) Date of publication of application: 09.02.2022
(73) Proprietor: Services Pétroliers Schlumberger, 75007 Paris (FR); Geoquest Systems B.V., 2586 BJ The Hague (NL)
(72) Inventor: MISHRA, Shubham, Indira Nagar, Lucknow 226015 (IN); OJHA, Aditya, Lahurabir Varanasi 221010 (IN); SHRIVASTAVA, Chandramani, Mumbai 400101 (IN)
(74) Representative: Schlumberger Intellectual Property Department
(86) International application number: PCT/US2020/024429
(87) International publication number: WO 2020/198210

(56) References cited:
- US-A1- 2002 053 430
- US-A1- 2014 257 706
- US-A1- 2018 058 211
- US-A1- 2018 348 395
- US-A1- 2019 025 461
- No further relevant documents disclosed

## Description

### Background

Exploitation of hydrocarbon reservoirs has been a challenge due to uncertainties posed by subsurface heterogeneities that are often not factored into field development plans. Secondary and tertiary recovery mechanisms, such as waterflooding and enhanced oil recovery (EOR), are used to enhance the oilfield recovery beyond primary recovery. However, as the field development transitions to secondary/tertiary mechanisms, the challenges in monitoring these mechanisms further increase the uncertainty in field development. If these uncertainties are not reduced or incorporated properly, the field development may easily become uneconomical.

US2014/257706 A1 describes a method for geological formation analysis comprising collecting time-lapsed well-based measurement data from a first borehole in a geological formation over a measurement time period and collecting time-lapsed electromagnetic (EM) cross-well measurement data via a plurality of spaced-apart second boreholes in the geological formation over the measurement time period. The method further includes determining simulated changes to a hydrocarbon resource in the geological formation over the measurement time period based upon a geological model using a processor, and using the processor to determine if the simulated changes are within an error threshold of the time-lapsed well-based measurement data and the time-lapsed cross-well EM measurement data. If the simulated changes are not within the error threshold, then the geological model may be updated.

### Summary

The present invention resides in a method for modeling a subterranean formation as defined in claim 1. Preferred embodiments are defined in the dependent claims.

### Brief Description of the Drawings

The accompanying drawings, which are incorporated in and constitute a part of this specification, illustrate embodiments of the present teachings and together with the description, serve to explain the principles of the present teachings. In the figures:
Figures 1A, 1B, 1C, 1D, 2, 3A, and 3B illustrate simplified, schematic views of an oilfield and its operation, according to an embodiment.
Figure 4 illustrates a flowchart of a method for modeling a subterranean formation, according to an embodiment.
Figure 5 illustrates a schematic view of cross-well electromagnetic (EM) data acquisition, according to an embodiment.
Figure 6 illustrates a schematic view of a two-stage petrophysical joint inversion (PJI) workflow, according to an embodiment.
Figure 7 illustrates a schematic view of a calibration algorithm, according to an embodiment.
Figures 8A and 8B illustrate graphs showing variables variation for calibration and selection with minimal root mean square error (RMSE), according to an embodiment. More particularly, Figure 8A illustrates a graph showing variables varied to calibrate the RMSE, and Figure 8B illustrates a graph showing a fitness calibration.
Figure 9 illustrates a schematic view of an iterative porosity calibration in a static geo-cellular model, according to an embodiment.
Figure 10 illustrates a schematic view of an iterative saturation calibration process in a dynamic reservoir model, according to an embodiment.
Figure 11 illustrates a computing system for performing at least a portion of the method(s) disclosed herein, according to an embodiment.

### Detailed Description

Reference will now be made in detail to embodiments, examples of which are illustrated in the accompanying drawings and figures. In the following detailed description, numerous specific details are set forth in order to provide a thorough understanding of the invention. However, it will be apparent to one of ordinary skill in the art that the invention may be practiced without these specific details. In other instances, well-known methods, procedures, components, circuits and networks have not been described in detail so as not to unnecessarily obscure aspects of the embodiments.

It will also be understood that, although the terms first, second, etc. may be used herein to describe various elements, these elements should not be limited by these terms. These terms are only used to distinguish one element from another. For example, a first object could be termed a second object, and, similarly, a second object could be termed a first object, without departing from the scope of the invention. The first object and the second object are both objects, respectively, but they are not to be considered the same object.

The terminology used in the description of the invention herein is for the purpose of describing particular embodiments only and is not intended to be limiting of the invention. As used in the description of the invention and the appended claims, the singular forms "a," "an" and "the" are intended to include the plural forms as well, unless the context clearly indicates otherwise. It will also be understood that the term "and/or" as used herein refers to and encompasses any possible combinations of one or more of the associated listed items. It will be further understood that the terms "includes," "including," "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Further, as used herein, the term "if" may be construed to mean "when" or "upon" or "in response to determining" or "in response to detecting," depending on the context.

Attention is now directed to processing procedures, methods, techniques and workflows that are in accordance with some embodiments. Some operations in the processing procedures, methods, techniques and workflows disclosed herein may be combined and/or the order of some operations may be changed.

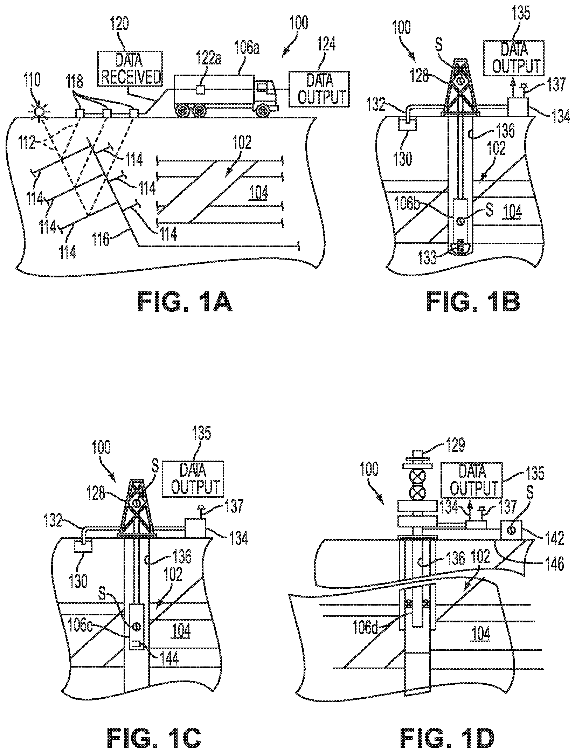

Figures 1A-1D illustrate simplified, schematic views of oilfield 100 having subterranean formation 102 containing reservoir 104 therein in accordance with implementations of various technologies and techniques described herein. Figure 1A illustrates a survey operation being performed by a survey tool, such as seismic truck 106.1, to measure properties of the subterranean formation. The survey operation is a seismic survey operation for producing sound vibrations. In Figure 1A, one such sound vibration, e.g., sound vibration 112 generated by source 110, reflects off horizons 114 in earth formation 116. A set of sound vibrations is received by sensors, such as geophone-receivers 118, situated on the earth's surface. The data received 120 is provided as input data to a computer 122.1 of a seismic truck 106.1, and responsive to the input data, computer 122.1 generates seismic data output 124. This seismic data output may be stored, transmitted or further processed as desired, for example, by data reduction.

Figure 1B illustrates a drilling operation being performed by drilling tools 106.2 suspended by rig 128 and advanced into subterranean formations 102 to form wellbore 136. Mud pit 130 is used to draw drilling mud into the drilling tools via flow line 132 for circulating drilling mud down through the drilling tools, then up wellbore 136 and back to the surface. The drilling mud is typically filtered and returned to the mud pit. A circulating system may be used for storing, controlling, or filtering the flowing drilling mud. The drilling tools are advanced into subterranean formations 102 to reach reservoir 104. Each well may target one or more reservoirs. The drilling tools are adapted for measuring downhole properties using logging while drilling tools. The logging while drilling tools may also be adapted for taking core sample 133 as shown.

Computer facilities may be positioned at various locations about the oilfield 100 (e.g., the surface unit 134) and/or at remote locations. Surface unit 134 may be used to communicate with the drilling tools and/or offsite operations, as well as with other surface or downhole sensors. Surface unit 134 is capable of communicating with the drilling tools to send commands to the drilling tools, and to receive data therefrom. Surface unit 134 may also collect data generated during the drilling operation and produce data output 135, which may then be stored or transmitted.

Sensors (S), such as gauges, may be positioned about oilfield 100 to collect data relating to various oilfield operations as described previously. As shown, sensor (S) is positioned in one or more locations in the drilling tools and/or at rig 128 to measure drilling parameters, such as weight on bit, torque on bit, pressures, temperatures, flow rates, compositions, rotary speed, and/or other parameters of the field operation. Sensors (S) may also be positioned in one or more locations in the circulating system.

Drilling tools 106.2 may include a bottom hole assembly (BHA) (not shown), generally referenced, near the drill bit (e.g., within several drill collar lengths from the drill bit). The bottom hole assembly includes capabilities for measuring, processing, and storing information, as well as communicating with surface unit 134. The bottom hole assembly further includes drill collars for performing various other measurement functions.

The bottom hole assembly may include a communication subassembly that communicates with surface unit 134. The communication subassembly is adapted to send signals to and receive signals from the surface using a communications channel such as mud pulse telemetry, electro-magnetic telemetry, or wired drill pipe communications. The communication subassembly may include, for example, a transmitter that generates a signal, such as an acoustic or electromagnetic signal, which is representative of the measured drilling parameters. It will be appreciated by one of skill in the art that a variety of telemetry systems may be employed, such as wired drill pipe, electromagnetic or other known telemetry systems.

Typically, the wellbore is drilled according to a drilling plan that is established prior to drilling. The drilling plan typically sets forth equipment, pressures, trajectories and/or other parameters that define the drilling process for the wellsite. The drilling operation may then be performed according to the drilling plan. However, as information is gathered, the drilling operation may need to deviate from the drilling plan. Additionally, as drilling or other operations are performed, the subsurface conditions may change. The earth model may also need adjustment as new information is collected

The data gathered by sensors (S) may be collected by surface unit 134 and/or other data collection sources for analysis or other processing. The data collected by sensors (S) may be used alone or in combination with other data. The data may be collected in one or more databases and/or transmitted on or offsite. The data may be historical data, real time data, or combinations thereof. The real time data may be used in real time, or stored for later use. The data may also be combined with historical data or other inputs for further analysis. The data may be stored in separate databases, or combined into a single database.

Surface unit 134 may include transceiver 137 to allow communications between surface unit 134 and various portions of the oilfield 100 or other locations. Surface unit 134 may also be provided with or functionally connected to one or more controllers (not shown) for actuating mechanisms at oilfield 100. Surface unit 134 may then send command signals to oilfield 100 in response to data received. Surface unit 134 may receive commands via transceiver 137 or may itself execute commands to the controller. A processor may be provided to analyze the data (locally or remotely), make the decisions and/or actuate the controller. In this manner, oilfield 100 may be selectively adjusted based on the data collected. This technique may be used to optimize (or improve) portions of the field operation, such as controlling drilling, weight on bit, pump rates, or other parameters. These adjustments may be made automatically based on computer protocol, and/or manually by an operator. In some cases, well plans may be adjusted to select optimum (or improved) operating conditions, or to avoid problems.

Figure 1C illustrates a wireline operation being performed by wireline tool 106.3 suspended by rig 128 and into wellbore 136 of Figure 1B. Wireline tool 106.3 is adapted for deployment into wellbore 136 for generating well logs, performing downhole tests and/or collecting samples. Wireline tool 106.3 may be used to provide another method and apparatus for performing a seismic survey operation. Wireline tool 106.3 may, for example, have an explosive, radioactive, electrical, or acoustic energy source 144 that sends and/or receives electrical signals to surrounding subterranean formations 102 and fluids therein.

Wireline tool 106.3 may be operatively connected to, for example, geophones 118 and a computer 122.1 of a seismic truck 106.1 of Figure 1A. Wireline tool 106.3 may also provide data to surface unit 134. Surface unit 134 may collect data generated during the wireline operation and may produce data output 135 that may be stored or transmitted. Wireline tool 106.3 may be positioned at various depths in the wellbore 136 to provide a survey or other information relating to the subterranean formation 102.

Sensors (S), such as gauges, may be positioned about oilfield 100 to collect data relating to various field operations as described previously. As shown, sensor S is positioned in wireline tool 106.3 to measure downhole parameters which relate to, for example porosity, permeability, fluid composition and/or other parameters of the field operation.

Figure 1D illustrates a production operation being performed by production tool 106.4 deployed from a production unit or Christmas tree 129 and into completed wellbore 136 for drawing fluid from the downhole reservoirs into surface facilities 142. The fluid flows from reservoir 104 through perforations in the casing (not shown) and into production tool 106.4 in wellbore 136 and to surface facilities 142 via gathering network 146.

Sensors (S), such as gauges, may be positioned about oilfield 100 to collect data relating to various field operations as described previously. As shown, the sensor (S) may be positioned in production tool 106.4 or associated equipment, such as Christmas tree 129, gathering network 146, surface facility 142, and/or the production facility, to measure fluid parameters, such as fluid composition, flow rates, pressures, temperatures, and/or other parameters of the production operation.

Production may also include injection wells for added recovery. One or more gathering facilities may be operatively connected to one or more of the wellsites for selectively collecting downhole fluids from the wellsite(s).

While Figures 1B-1D illustrate tools used to measure properties of an oilfield, it will be appreciated that the tools may be used in connection with non-oilfield operations, such as gas fields, mines, aquifers, storage or other subterranean facilities. Also, while certain data acquisition tools are depicted, it will be appreciated that various measurement tools capable of sensing parameters, such as seismic two-way travel time, density, resistivity, production rate, etc., of the subterranean formation and/or its geological formations may be used. Various sensors (S) may be located at various positions along the wellbore and/or the monitoring tools to collect and/or monitor the desired data. Other sources of data may also be provided from offsite locations.

The field configurations of Figures 1A-1D are intended to provide a brief description of an example of a field usable with oilfield application frameworks. Part of, or the entirety, of oilfield 100 may be on land, water and/or sea. Also, while a single field measured at a single location is depicted, oilfield applications may be utilized with any combination of one or more oilfields, one or more processing facilities and one or more wellsites.

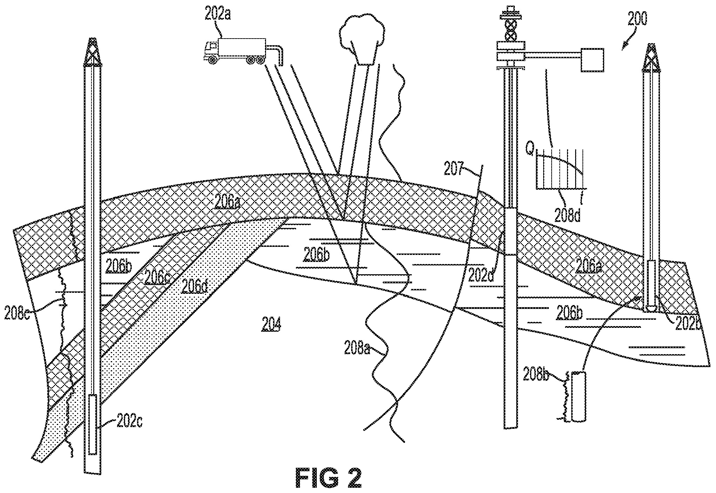

Figure 2 illustrates a schematic view, partially in cross section of oilfield 200 having data acquisition tools 202.1, 202.2, 202.3 and 202.4 positioned at various locations along oilfield 200 for collecting data of subterranean formation 204 in accordance with implementations of various technologies and techniques described herein. Data acquisition tools 202.1-202.4 may be the same as data acquisition tools 106.1-106.4 of Figures 1A-1D, respectively, or others not depicted. As shown, data acquisition tools 202.1-202.4 generate data plots or measurements 208.1-208.4, respectively. These data plots are depicted along oilfield 200 to demonstrate the data generated by the various operations.

Data plots 208.1-208.3 are examples of static data plots that may be generated by data acquisition tools 202.1-202.3, respectively; however, it should be understood that data plots 208.1-208.3 may also be data plots that are updated in real time. These measurements may be analyzed to better define the properties of the formation(s) and/or determine the accuracy of the measurements and/or for checking for errors. The plots of each of the respective measurements may be aligned and scaled for comparison and verification of the properties.

Static data plot 208.1 is a seismic two-way response over a period of time. Static plot 208.2 is core sample data measured from a core sample of the formation 204. The core sample may be used to provide data, such as a graph of the density, porosity, permeability, or some other physical property of the core sample over the length of the core. Tests for density and viscosity may be performed on the fluids in the core at varying pressures and temperatures. Static data plot 208.3 is a logging trace that typically provides a resistivity or other measurement of the formation at various depths.

A production decline curve or graph 208.4 is a dynamic data plot of the fluid flow rate over time. The production decline curve typically provides the production rate as a function of time. As the fluid flows through the wellbore, measurements are taken of fluid properties, such as flow rates, pressures, composition, etc.

Other data may also be collected, such as historical data, user inputs, economic information, and/or other measurement data and other parameters of interest. As described below, the static and dynamic measurements may be analyzed and used to generate models of the subterranean formation to determine characteristics thereof. Similar measurements may also be used to measure changes in formation aspects over time.

The subterranean structure 204 has a plurality of geological formations 206.1-206.4. As shown, this structure has several formations or layers, including a shale layer 206.1, a carbonate layer 206.2, a shale layer 206.3 and a sand layer 206.4. A fault 207 extends through the shale layer 206.1 and the carbonate layer 206.2. The static data acquisition tools are adapted to take measurements and detect characteristics of the formations.

While a specific subterranean formation with specific geological structures is depicted, it will be appreciated that oilfield 200 may contain a variety of geological structures and/or formations, sometimes having extreme complexity. In some locations, typically below the water line, fluid may occupy pore spaces of the formations. Each of the measurement devices may be used to measure properties of the formations and/or its geological features. While each acquisition tool is shown as being in specific locations in oilfield 200, it will be appreciated that one or more types of measurement may be taken at one or more locations across one or more fields or other locations for comparison and/or analysis.

The data collected from various sources, such as the data acquisition tools of Figure 2, may then be processed and/or evaluated. Typically, seismic data displayed in static data plot 208.1 from data acquisition tool 202.1 is used by a geophysicist to determine characteristics of the subterranean formations and features. The core data shown in static plot 208.2 and/or log data from well log 208.3 are typically used by a geologist to determine various characteristics of the subterranean formation. The production data from graph 208.4 is typically used by the reservoir engineer to determine fluid flow reservoir characteristics. The data analyzed by the geologist, geophysicist and the reservoir engineer may be analyzed using modeling techniques.

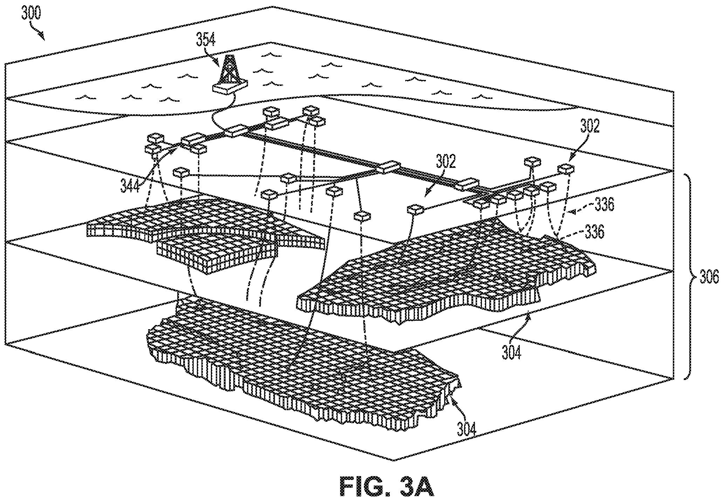

Figure 3A illustrates an oilfield 300 for performing production operations in accordance with implementations of various technologies and techniques described herein. As shown, the oilfield has a plurality of wellsites 302 operatively connected to central processing facility 354. The oilfield configuration of Figure 3A is not intended to limit the scope of the oilfield application system. Part, or all, of the oilfield may be on land and/or sea. Also, while a single oilfield with a single processing facility and a plurality of wellsites is depicted, any combination of one or more oilfields, one or more processing facilities and one or more wellsites may be present.

Each wellsite 302 has equipment that forms wellbore 336 into the earth. The wellbores extend through subterranean formations 306 including reservoirs 304. These reservoirs 304 contain fluids, such as hydrocarbons. The wellsites draw fluid from the reservoirs and pass them to the processing facilities via surface networks 344. The surface networks 344 have tubing and control mechanisms for controlling the flow of fluids from the wellsite to processing facility 354.

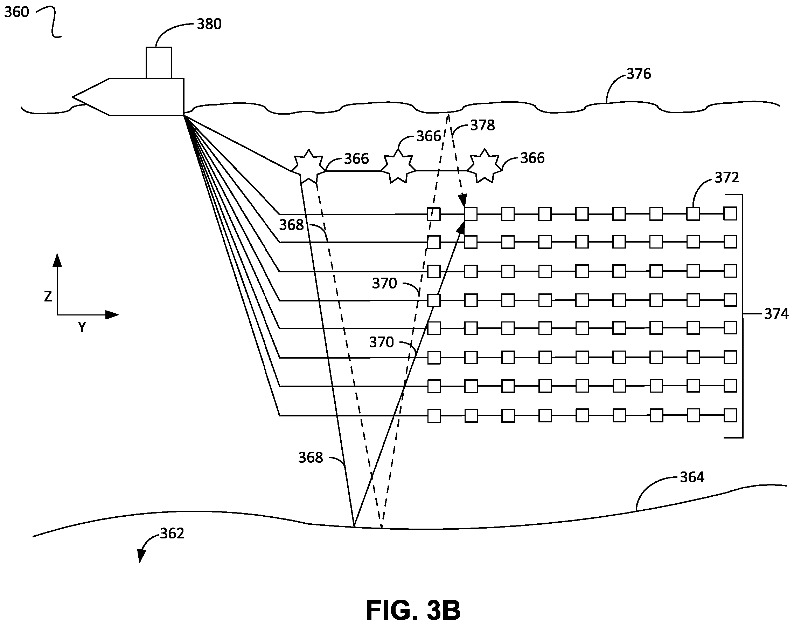

Attention is now directed to Figure 3B, which illustrates a side view of a marine-based survey 360 of a subterranean subsurface 362 in accordance with one or more implementations of various techniques described herein. Subsurface 362 includes seafloor surface 364. Seismic sources 366 may include marine sources such as vibroseis or airguns, which may propagate seismic waves 368 (e.g., energy signals) into the Earth over an extended period of time or at a nearly instantaneous energy provided by impulsive sources. The seismic waves may be propagated by marine sources as a frequency sweep signal. For example, marine sources of the vibroseis type may initially emit a seismic wave at a low frequency (e.g., 5 Hz) and increase the seismic wave to a high frequency (e.g., 80-90Hz) over time.

The component(s) of the seismic waves 368 may be reflected and converted by seafloor surface 364 (i.e., reflector), and seismic wave reflections 370 may be received by a plurality of seismic receivers 372. Seismic receivers 372 may be disposed on a plurality of streamers (i.e., streamer array 374). The seismic receivers 372 may generate electrical signals representative of the received seismic wave reflections 370. The electrical signals may be embedded with information regarding the subsurface 362 and captured as a record of seismic data.

In one implementation, each streamer may include streamer steering devices such as a bird, a deflector, a tail buoy and the like, which are not illustrated in this application. The streamer steering devices may be used to control the position of the streamers in accordance with the techniques described herein.

In one implementation, seismic wave reflections 370 may travel upward and reach the water/air interface at the water surface 376, a portion of reflections 370 may then reflect downward again (i.e., sea-surface ghost waves 378) and be received by the plurality of seismic receivers 372. The sea-surface ghost waves 378 may be referred to as surface multiples. The point on the water surface 376 at which the wave is reflected downward is generally referred to as the downward reflection point.

The electrical signals may be transmitted to a vessel 380 via transmission cables, wireless communication or the like. The vessel 380 may then transmit the electrical signals to a data processing center. Alternatively, the vessel 380 may include an onboard computer capable of processing the electrical signals (i.e., seismic data). Those skilled in the art having the benefit of this disclosure will appreciate that this illustration is highly idealized. For instance, surveys may be of formations deep beneath the surface. The formations may typically include multiple reflectors, some of which may include dipping events, and may generate multiple reflections (including wave conversion) for receipt by the seismic receivers 372. In one implementation, the seismic data may be processed to generate a seismic image of the subsurface 362.

Marine seismic acquisition systems tow each streamer in streamer array 374 at the same depth (e.g., 5-10m). However, marine based survey 360 may tow each streamer in streamer array 374 at different depths such that seismic data may be acquired and processed in a manner that avoids the effects of destructive interference due to sea-surface ghost waves. For instance, marine-based survey 360 of Figure 3B illustrates eight streamers towed by vessel 380 at eight different depths. The depth of each streamer may be controlled and maintained using the birds disposed on each streamer.

### Redefining Waterflood Surveillance by Validating Streamline Simulation with Deep-Look Electromagnetic (EM) Time-Lapse Surveys

Waterflood is a field development scheme used for secondary recovery of hydrocarbons. Successfully managing a waterflood scheme relies on reservoir characterization that uses a variety of subsurface measurements and the integration of these measurements into a reservoir model.

Electrical resistivity is a tool in formation evaluation of oil and gas reservoirs. For example, electrical resistivity is used in downhole logging to locate and analyze reservoir rocks, to perform fluid dynamics, and design well completions. Reservoir models may be used to map fluid flow to exploit the reservoir. Fluid saturation away from the well may be useful to help generate reservoir models. Measuring or determining fluid saturation may be achieved by integrating a deep investigation of resistivity with the reservoir models.

Measuring or determining fluid saturation may be accomplished by applying tools that are sensitive to an inter-well (i.e., between two or more wells) environment. One of these tools is inductive deep-look electromagnetics (EM) or cross-well EM. Cross-well EM is an induction-based tomography technology that inductively measures the inter-well resistivity between two or more wells. This technology, particularly useful for tracking water and steam floods or mapping residual saturation, is also used to enhance sweep efficiency, identify bypassed pay, and predict fluid-related issues such as water breakthrough.

Cross-well EM/seismic analysis techniques may provide results in inter-well space at high resolution. Thus, uncertainty in reservoir models in the inter-well space can be reduced by integrating them with cross-well EM/seismic data. While cross-well seismic techniques are specifically applicable in environments where the density difference between the fluids is large enough for seismic techniques to detect, EM may be useful in oil-water environments where the density difference between the fluids is not large enough for seismic techniques to detect. Therefore, calibrating reservoir models with cross-well EM data may reduce uncertainty in fluid system reservoirs.

The present disclosure integrates streamlines with deep-look EM data/analysis to better determine the flowpath of the injected fluid, thus also determining the flowpath of resident fluids. The streamlines generated may be revised until a reasonable match of streamlines with deep-look EM is achieved. Once a close match between the two is achieved, a dynamic model can be used to determine the effectiveness of waterflooding and further design multiple scenarios of field development, such as enhanced oil recovery (EOR) implementation, infill well planning, etc.

As the original energy of a reservoir depletes with production, and the reservoir is no longer able to support the production of hydrocarbons up to the surface, even with an artificial lift, secondary recovery mechanisms are employed to continue the production. One method of restoring and maintaining reservoir energy is to inject water into the reservoir. This is known as waterflooding. However, waterflooding has its own challenges related to design, execution, and surveillance. The success of a waterflooding project may depend upon a well-planned and well-executed program of surveillance and monitoring. At one time, waterflood surveillance included aspects of reservoir performance, but with the application of the reservoir management approach, the industry's focus shifted to include wells, facilities, operating conditions, etc. in surveillance programs. There are various surveillance factors to be considered for a successful waterflood process, including precise reservoir analysis. A detailed reservoir analysis may facilitate accurate waterflood monitoring and real-time decisions to modify the ongoing waterflood for economic development of the field.

From the aspect of reservoir analysis, there may be two ways of monitoring a waterflood: locally, which is restricted to the small part of the field close to the injectors, and globally, which operates at the field level and incorporates the full-field performance of the waterflood. The local methods of monitoring a waterflood include data acquisition approaches such as deep-look time-lapse cross-well EM and tracers. The global methods for understanding, analyzing, planning, and predicting waterflood development include modeling approaches such as tank models, fractional-flow models, or simulation models. One example of these modeling approaches includes or otherwise involves streamline simulation. Both of these methods (i.e., local and global) have limitations that affect the accuracy of waterflood surveillance and cause uncertainty during field development. However, the two methods may complement each other, if combined in a logical manner, to generate an accurate waterflood surveillance scheme. The present disclosure describes an approach that uses a combination of local and global methods of waterflood surveillance (e.g., deep-look time-lapse cross-well EM as an example of local methods and streamline simulation as an example of global methods) and explains how a logical workflow to combine these two methods can generate a strong water surveillance scheme.

As mentioned above, streamline simulation may be used for hydrocarbon reservoir simulation. A streamline may be considered to be a line that is tangential to the local velocity field at a given instant of time. Streamline-based flow simulation differentiates itself from cell-based simulation techniques, such as finite-differences and finite-elements, in that phase saturations and components are transported along a flow-based grid defined by streamlines (or streamtubes) rather than moved from cell-to-cell. The objective is to capture how injected reservoir volumes (e.g., water) displace resident reservoir volumes, which may aid in understanding waterflood management. Streamline simulation encompasses multiple assumptions (e.g., capillary pressure effects are not considered, lift curves are used for reporting, limited well management capability, etc.) and does not have as wide an application as finite difference simulations. However, a waterflood in an oil-water fluid system is a case where streamline simulation can be applied.

Waterflood management at a full-field level has been studied through two approaches: static allocation by analytical methods, and sensitivities in numerical simulation. Whereas analytical methods largely provide results of injection behavior, water influx, and fluid movement at a time-step and not over time, finite difference simulations use large amounts of computational time for such sensitivities and have a limitation on resolution (e.g., cell-size) to maintain a reasonable simulation time. Therefore, streamline simulation is a tool to monitor and improve large waterfloods at a full-field level because it provides an efficient method to model and predict detailed fluid movement.

There is, however, a limitation in full-field modeling approaches that limits their use as a method for waterflood management. This limitation is common to streamline simulation as well. The streamlines generated are largely dependent on the modeled geology of the field, and because the geology between the wells is uncertain (e.g., mostly modeled either based on statistical methods or deterministic methods), there is inherent uncertainty in the generated streamlines. This uncertainty can have widespread impacts on the waterflood development program of the field and hence the project economics. Streamlines, if validated, can help in mitigating an uncertainty existing in today's reservoir analysis methodology (e.g., uncertainty in flow paths between wells) and thus help an operator prepare an appropriate large-scale waterflood development plan or EOR development of a brownfield (e.g., subsequently with the development of streamlines to handle more than 2-phase black oil cases).

As mentioned above, cross-well EM is an induction-based tomography technology that measures the inter-well resistivity between two or more wells. The data acquisition strategy involves moving (e.g., raising and lowering) a transmitter in one well and measuring the transmitted signals in a second well with a stationary receiver array. After a specified depth interval is logged in the first and/or second wells, the transmitter and/or the receiver(s) is/are moved to a new depth, and the process is repeated until the logging interval is covered by both the transmitter and the receiver(s). A data point may include stacking a monochromatic sine wave a plurality (e.g., hundreds or thousands) of times. An entire data set may include about 15-60 separate receiver positions covering the depth range of interest, so a string of receivers may be used to reduce the data acquisition time. Capturing an entire data set may take from about 12 to 36 hours depending on the tools available, the well conditions, and the well separation. Therefore, a comprehensive workflow incorporating streamline simulation and cross-well EM may address the uncertainty in waterflood surveillance and aid in subsequent field development.

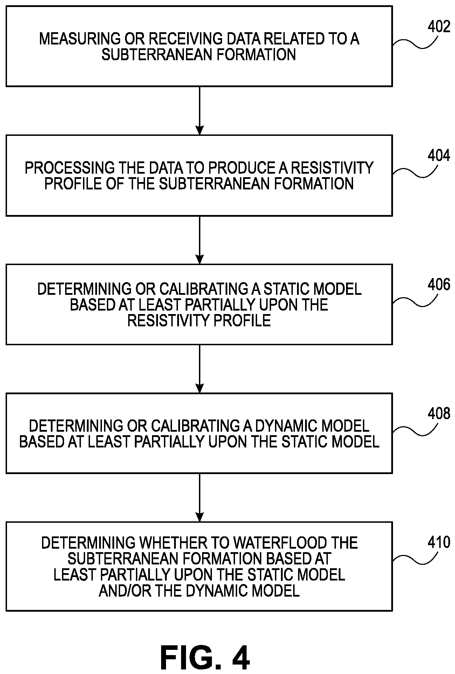

Figure 4 illustrates a flowchart of a method 400 for modelling a subterranean formation, according to an embodiment.

### Data Acquisition and Interpretation

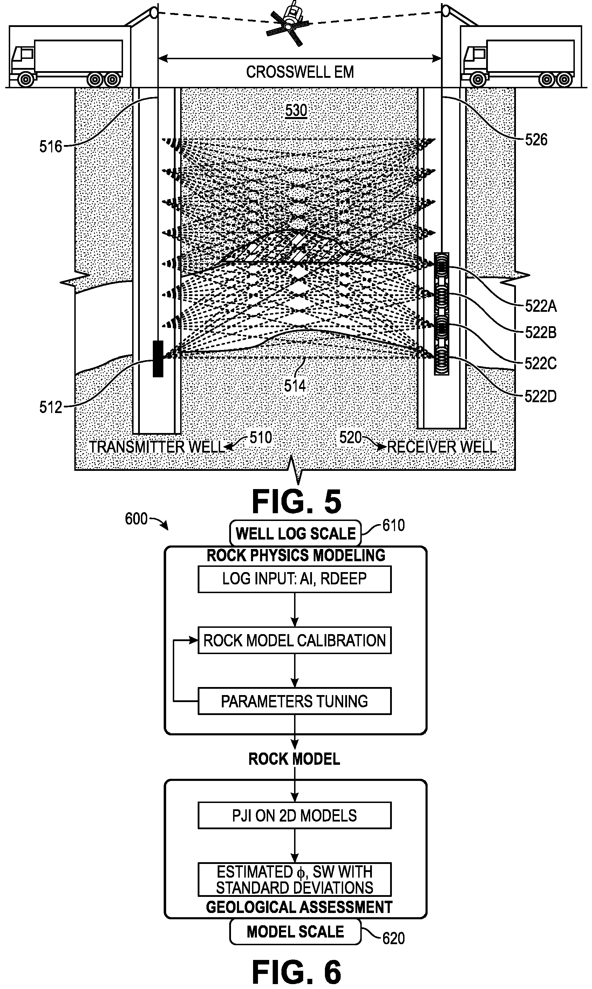

The method 400 may include measuring or receiving data representing (or collected from) a subterranean formation, as at 402. The data may be or include (e.g., time-lapse) cross-well EM data. The cross-well EM data may be in the form of superposed primary and secondary electric fields between two or more wells. An example of this is shown in Figure 5, which illustrates a schematic view of cross-well electromagnetic (EM) data acquisition.

As shown in Figure 5, a first well 510 and a second well 520 are formed in a subterranean formation 530. The first well 510 may have a transmitter 512 positioned therein. The transmitter 512 may be configured to transmit EM signals 514 into the subterranean formation 530. The transmitter 512 may be raised and lowered to a plurality of different depths within the first well 510 (e.g., by a cable 516) to transmit the EM signals 514 at/from the plurality of different depths.

The second well 520 may have one or more receivers positioned therein. As shown, four receivers 522A-522D are axially-adjacent to one another with respect to a central longitudinal axis through the second well 520. Thus, the receivers 522A-522D may be positioned at a plurality of different depths within the second well 520. The receivers 522A-522D may receive/measure the EM signals 514 transmitted from the transmitter 512. The receivers 522A-522D may be raised and lowered to a plurality of different depths within the second well 520 (e.g., by a cable 526) to receive/measure the EM signals 514 at the plurality of different depths.

Returning to Figure 4, the method 400 may also include processing the data (e.g., the cross-well EM data) to produce a resistivity profile of the subterranean formation, as at 404. More particularly, the amplitude of the EM signals 514 received/measured by the receivers 522A-522D may be processed using tomographic inversion to produce a resistivity profile of the subterranean formation 530 in a two-dimensional (2D) section (also referred to as a 2D plane) between the first and second wells 510, 520. There may be an inherent uncertainty in the inversion of the cross-well EM data to resistivity. In at least one embodiment, a seismic-petrophysics calibration may be used to reduce the uncertainty in the inversion.

The derived resistivity information may be used to calibrate one or more static geo-cellular model(s) and dynamic reservoir model(s), as described below. In addition, the reduction in uncertainty of reservoir characterization and fluid saturation mapping may become more robust if the cross-well EM data is acquired in a time-lapse manner, across one or more well groups in the field.

### Static Geo-Cellular Model (GCM) Calibration

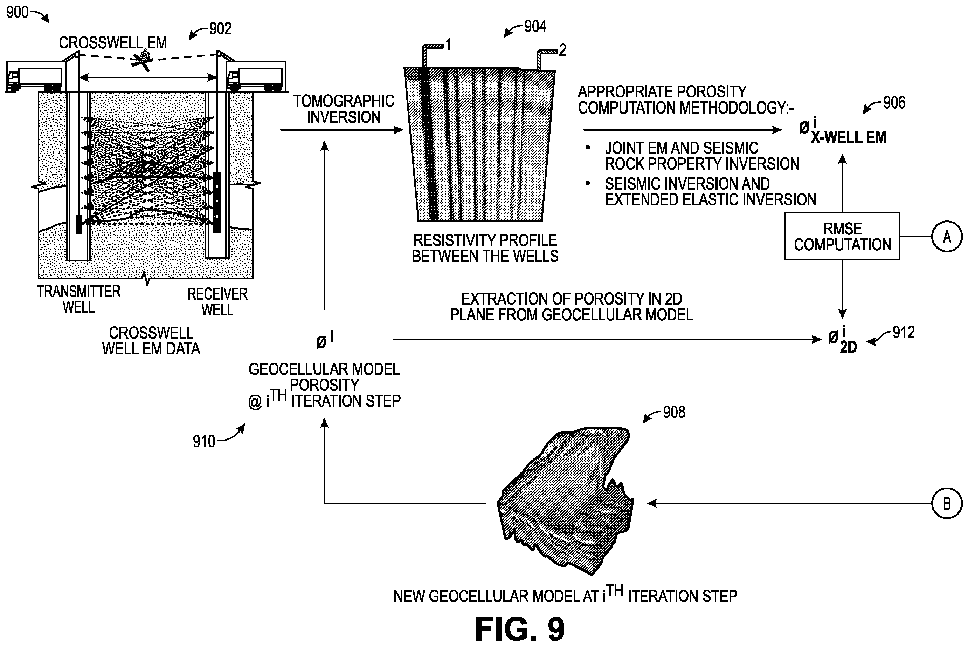

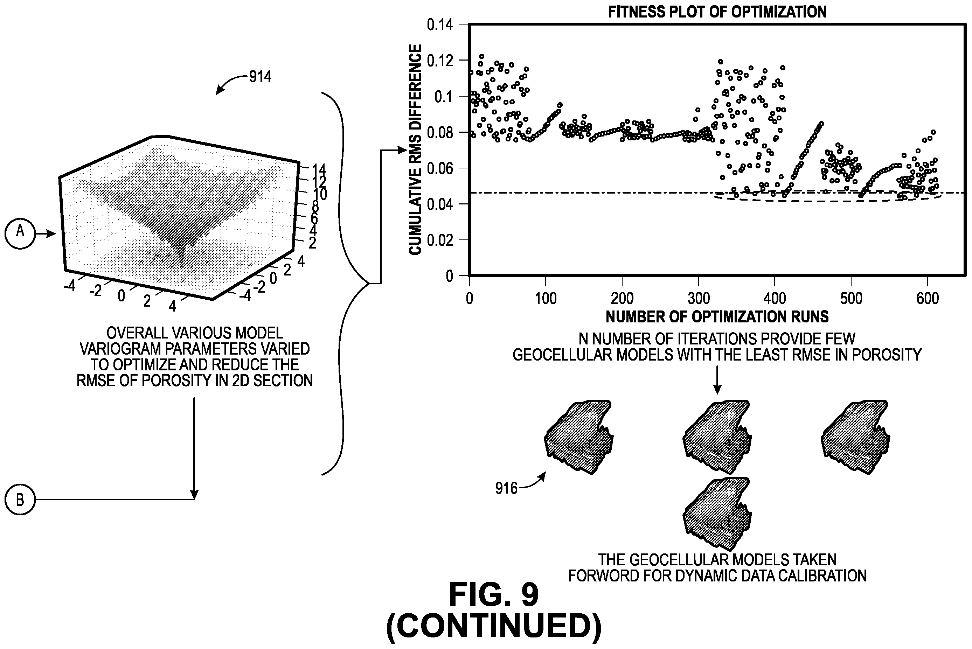

The method 400 may also include determining a static model of the subterranean formation based at least partially upon the resistivity profile, as at 406. More particularly, this may include determining, calibrating, and/or estimating a porosity distribution in a static GCM based at least partially upon the resistivity profile derived from the cross-well EM data between the wells 510, 520. Two techniques are described below to estimate the porosity and saturation along the 2D section between the wells 510, 520. A more detailed description of static GCM calibration is described below with respect to Figure 9.

### Technique One: Petrophysical Joint Inversion (PJI)

PJI exploits the outcomes from amplitude-versus-offset (AVO) seismic inversion (e.g., acoustic impedance) and cross-well EM inversion (e.g., electrical resistivity) to delineate the reservoir behavior in the seismic domain and the EM domain. Such geophysical properties are combined through a rock physics framework and jointly inverted to provide a quantitative description of the reservoir properties in terms of rock and fluid properties (e.g., porosity and fluid content). PJI supports the reservoir characterization through a robust petrophysical model that makes use of the complementary information contained in the multi-physics dataset such as cross-well and seismic AVO.

Figure 6 illustrates a schematic view of a two-stage PJI workflow 600: from a well-log scale 610 to a reservoir scale 620, according to an embodiment. The two-stage workflow 600 is based on a rock cross properties paradigm. First, a rock physics model is calibrated from the available well logs applying PJI to the acoustic impedance (AI) and deep resistivity logs. Second, the rock model is used to relate the reservoir's elastic and electrical properties (e.g., seismic and cross-well inversion derived) directly to underlying lithology and fluid properties with related uncertainties in terms of a-posteriori standard deviation.

### Technique Two: Seismic and Rock Physics Inversion

In embodiments where the gathered seismic data has higher angles (e.g., >35 degrees) with respect to a horizontal surface (e.g., a mean sea level can be considered a reference) that capture the AVO signature and a reliable acoustic impedance, a Vp/Vs ratio and/or a density can be derived within the seismic resolution. As used herein, Vp represents primary wave velocity, and Vs represents secondary wave velocity. These attributes can be used in equations governing a multi-attribute rock physics transform or a stochastic joint porosity saturation inversion to estimate porosity. The variable(s) in the equations involving hydrocarbons and water density may be obtained from a pressure-volume-temperature (PVT) laboratory analysis, and matrix density may be obtained from core analysis and/or well logs.

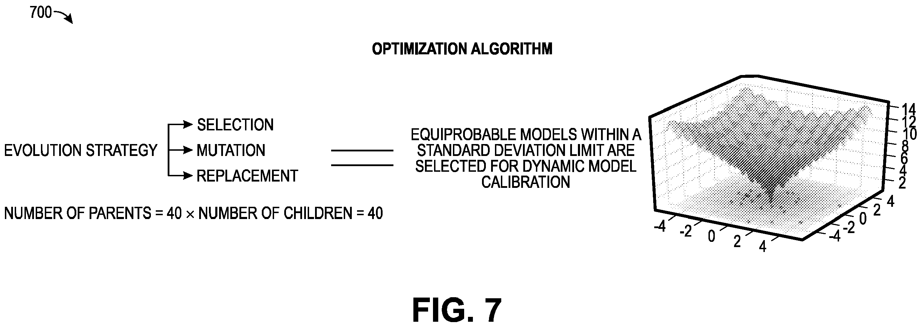

Figure 7 illustrates a schematic view of a calibrator 700, according to an embodiment. To validate the geological model with porosity distribution derived from cross-well EM data, the calibrator 700 may be used. The calibrator 700 works on evolutionary computation methodology of evolution strategy to minimize the root mean square error (RMSE) between the cross-well EM derived property and reservoir model property. To validate porosity, the calibrator 700 may change the global population of porosity in the geological model (e.g., by varying geostatistical population methods, variogram parameters, facies-biasing of porosity, well log upscaling, etc.) to match with the porosity derived from the cross-well EM data. The number of realizations of the static model for calibrating may be dependent upon the level of complexity and total acreage of the field under study. Once the RMSE between the two porosities in the 2D section is less than a predetermined amount, a group of models below a threshold RMSE are selected for dynamic model calibration. The porosity from the GCM is an input to derive the porosity in the 2D section from the cross-well resistivity. Thus, there is a high chance that the derived cross-well porosity may have a bias towards GCM porosity, particularly if the derivation is a single-step process. Therefore, an iterative process of porosity derivation may be used to avoid/reduce the bias of cross-well EM derived porosity on the GCM porosity.

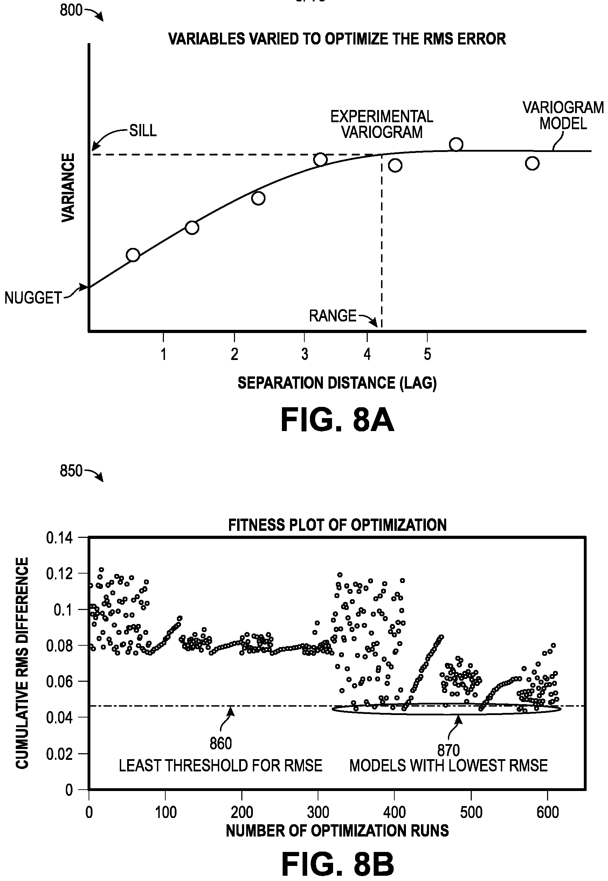

Figure 8A illustrates a graph 800 showing variables varied to calibrate the RMSE, according to an embodiment. More particularly, the graph 800 shows the variogram parameters used to geo-statistically populate a property (e.g., porosity) in a 3D reservoir model. These parameters may be derived from data analysis of well logs, and any change in these parameters may change the entire distribution of a property, essentially generating a new realization of 3D reservoir model. Figure 8B illustrates a graph 850 showing a fitness calibration, according to an embodiment. More particularly, the graph 850 shows a threshold 860 and a plurality of GCMs 870 that have a RMSE below the threshold 860.

### Dynamic Model Calibration

Returning to Figure 4, the method 400 may also include determining a dynamic model of the subterranean formation based at least partially upon one or more of the static (e.g., GCM) models, as at 408. More particularly, this may include determining, calibrating, and/or estimating a fluid (e.g., water or gas) saturation in a dynamic reservoir model based at least partially upon the resistivity profile derived from the cross-well EM data between the wells 510, 520 and/or the static GCM (from 406). For example, the dynamic reservoir model may be determined or calibrated based at least partially upon the one or more static (e.g., GCM) models 870 that have a RMSE below the threshold 860 (in Figure 8B).

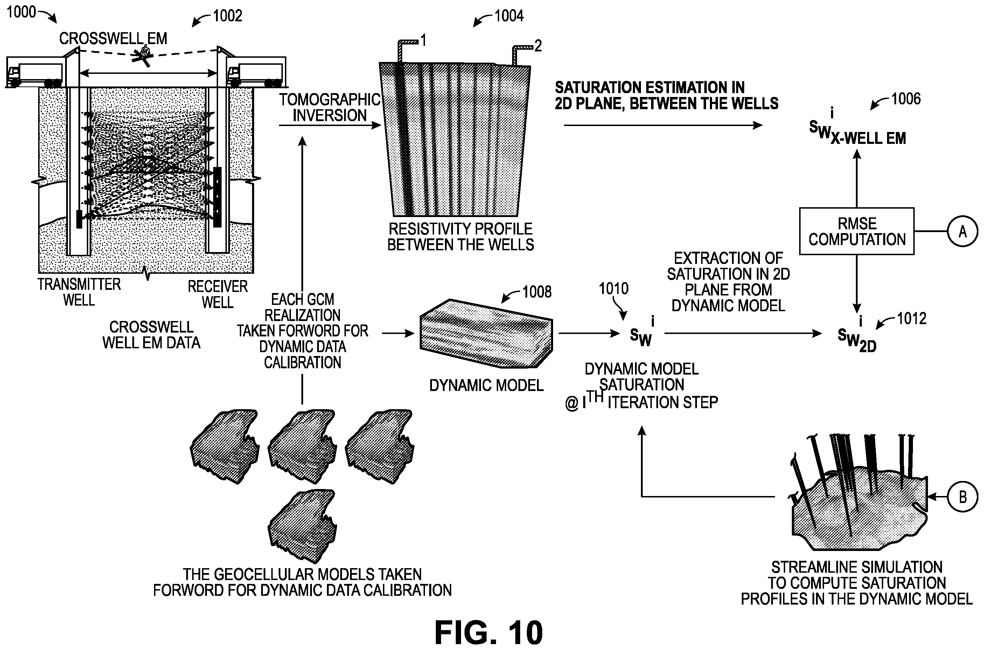

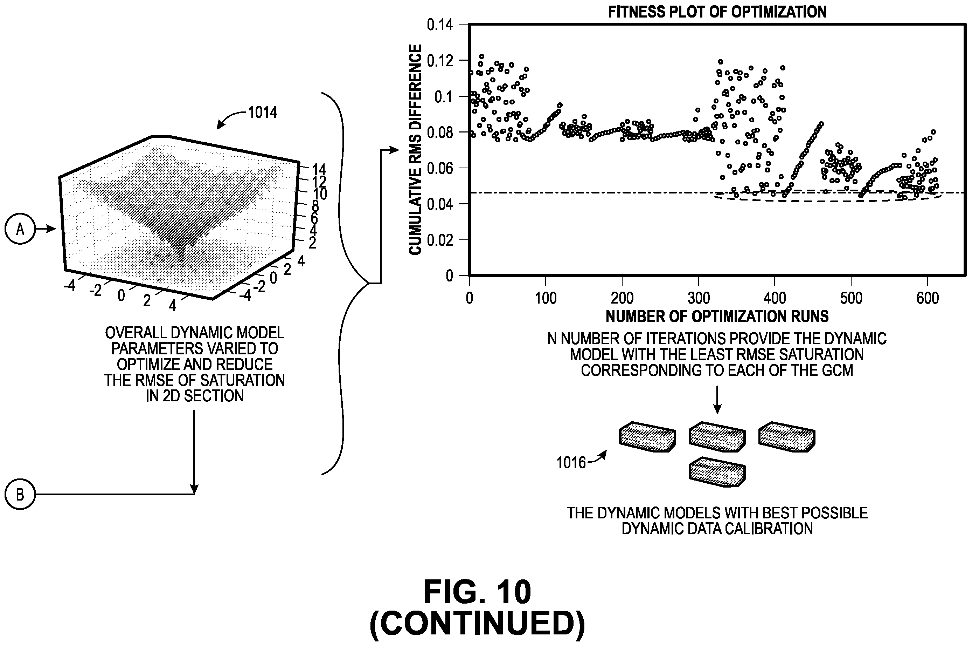

The dynamic reservoir model may be determined or calibrated against water saturation that is determined based at least partially upon the resistivity obtained from time lapse-cross-well EM data. The group of static GCM models 870 may be calibrated to match the cross-well EM derived water saturation (e.g., using the calibrator 700). At each time step where actual cross-well EM data has been acquired, the water saturation from the dynamic reservoir model may be regressed using the calibrator 700 until it closely matches with the water saturation calculated from cross-well EM data. The calibrator 700 may change the parameters in the dynamic reservoir model that affect fluid-flow for each flow-unit to match with the water saturation derived from time-lapse cross-well EM data. Streamline simulation becomes an effective simulation technique in this workflow because it reduces the timeline of calibration (e.g., through quick simulations) with a high-resolution solution (e.g., on a fine-scale model). A more detailed description of dynamic model calibration (e.g., saturation calibration) is described below with respect to Figure 10.

The reasoning behind selecting a plurality of static GCMs 870 for dynamic model calibration, instead of the one model with least RMSE, is to improve the possibility of achieving the most accurate calibrated model for water saturation.

The two-level (e.g., static and dynamic) calibration ensures that the uncertainty is sequentially reduced and the final dynamic reservoir model approaches a unique solution. The result of the calibration workflow is a calibrated geological and dynamic model, with reduced uncertainty and enhanced predictability.

A practical application of the method 400 includes determining whether to waterflood (or gasflood) the subterranean formation based at least partially upon the static GCM model and/or the dynamic model, as at 410. For example, a user may be able to design one or more scenarios of field development, such as EOR implementation, infill well planning, etc. Thus, the user may decide whether to inject fluid (e.g., water) into an injection well (e.g., the first well 510). The fluid may displace hydrocarbons (e.g., oil) in the subterranean formation 530 to one or more production wells (e.g., the second well 520), where the hydrocarbons may be recovered. In another embodiment, this may include performing the physical action of waterflooding (or gasflooding) the subterranean formation 530.

Figure 9 illustrates a schematic view of a method 900 for iteratively determining or calibrating porosity in a static geo-cellular model (GCM), according to an embodiment. The method 900 may include measuring or receiving cross-well EM data representing a subterranean formation, as at 902. This may be similar to 402 above. The method 900 may also include processing the cross-well EM data (e.g., using tomographic inversion) to produce a resistivity profile of the subterranean formation between the wells, as at 904. This may be similar to 404 above. The method 900 may also include determining or calibrating a porosity (e.g., in a 2D section) in the subterranean formation between the wells based at least partially upon the resistivity profile, as at 906. In one embodiment, the porosity may be determined or calibrated using joint EM and seismic rock property inversion, which is described in "technique one" above. In another embodiment, the porosity may be determined or calibrated using seismic inversion and extended elastic inversion, which is described in "technique two" above.

The method 900 may also include building or receiving a first static GCM of the subterranean formation, as at 908. The first static GCM may be built using well logs calibrated with core data, well tests, formation tests, etc. The first static GCM may also or instead be built using seismic data to derive horizons, faults, and trends for a 3D population of geological properties. The method 900 may also include determining or calibrating a porosity of the first static GCM, as at 910. As shown, in at least one embodiment, the porosity of the first static GCM may be used to help determine the resistivity profile. The method 900 may also include determining (e.g., extracting) the porosity in a 2D section of the first static GCM, as at 912.

The method 900 may also include varying one or more parameters of the first static GCM to vary the porosity in the (e.g., 2D section of the) first static GCM, thereby producing a second (e.g., updated) GCM, as at 914. The parameters may be or include variogram parameters (e.g., nugget, sill, range, seed number, etc.), geostatistical population parameters, facies-biasing (of porosity) parameters, well log upscaling parameters, or the like. The porosity in the 2D section of the first static GCM may be varied to vary (e.g., reduce) the RMSE between the 2D section of the first static GCM (from 910 and/or 912) and the 2D section based at least partially upon the resistivity profile (from 906). In other words, the porosity in the 2D section of the first static GCM (from 910 and/or 912) may be varied to more closely match the porosity in the 2D section based at least partially upon the resistivity profile (from 906). In at least one embodiment, at least a portion of 914 may be performed using the calibrator 700 in Figure 7.

As mentioned above, this produces the second static GCM, which may loop back to 908 for another iteration. The next iteration may be directed to the same 2D section (e.g., the same depth in the subterranean formation) or to a different 2D section (e.g., a different depth). Thus, a plurality of static GCMs may be produced by the plurality of iterations. The method 900 may also include selecting one or more of the plurality of static GCMs with a RMSE below a predetermined threshold, as at 916. An example of this is shown in Figure 8B and described above. The selected static GCMs may be used in the dynamic data calibration described below with respect to Figure 10.

Figure 10 illustrates a schematic view of a method 1000 for iteratively determining water saturation calibration in a dynamic reservoir model, according to an embodiment. The method 1000 may include measuring or receiving time-lapse cross-well EM data representing a subterranean formation, as at 1002. This may be similar to 402 and/or 902 above. The method 1000 may also include processing the time-lapse cross-well EM data (e.g., using tomographic inversion) to produce a resistivity profile of the subterranean formation between the wells, as at 1004. This may be similar to 404 and/or 904 above. The method 1000 may also include determining or calibrating a fluid (e.g., water) saturation (e.g., in a 2D section) in the subterranean formation between the wells based at least partially upon the resistivity profile, as at 1006.

The method 1000 may also include building or receiving a first dynamic reservoir model of the subterranean formation, as at 1008. The first dynamic reservoir model may be built using, or otherwise based at least partially upon, the selected static GCMs (from 916). The method 1000 may also include determining or calibrating a water saturation of the first dynamic reservoir model, as at 1010. The method 1000 may also include determining (e.g., extracting) the water saturation in a 2D section of the first dynamic reservoir model, as at 1012.

The method 1000 may also include varying one or more parameters of the first dynamic reservoir model to vary the water saturation in the (e.g., 2D section of the) first dynamic reservoir model, thereby producing a second (e.g., updated) dynamic reservoir model, as at 1014. The parameters may be or include fluid flow parameters such as relative permeability endpoints, corey constants, and saturation-height function, etc. The water saturation in the 2D section of the first dynamic reservoir model may be varied to vary (e.g., reduce) the RMSE between the 2D section of the first dynamic reservoir model (from 1010 and/or 1012) and the 2D section based at least partially upon the resistivity profile (from 1006). In other words, the water saturation in the 2D section of the first dynamic reservoir model (from 1010 and/or 1012) may be varied to more closely match the water saturation in the 2D section based at least partially upon the resistivity profile (from 1006). In at least one embodiment, at least a portion of 1014 may be performed using the calibrator 700 in Figure 7.

As mentioned above, this produces the second dynamic reservoir model, which may loop back to 1008 for another iteration. The next iteration may be directed to the same 2D section (e.g., the same depth in the subterranean formation) or to a different 2D section (e.g., a different depth). Thus, a plurality of dynamic reservoir models may be produced. In at least one embodiment, the different iterations may be performed, and the different dynamic reservoir models may be produced, using streamline simulation, which may reduce the timeline of calibration through quick simulations with high resolution (e.g., on a fine-scale model).

The method 1000 may also include selecting one or more of the plurality of dynamic reservoir models with a RMSE below a predetermined threshold, as at 1016. This is similar to the process shown in Figure 8B above. As describe above with respect to 410, the selected dynamic reservoir models may be used for the practical application of determining whether to waterflood the subterranean formation to recover hydrocarbons. This may include specific details related to which wells to inject, the type of fluid to inject, the pressure of the injected fluid, the flow rate of the injected fluid, the volume of the fluid to be injected, the recovery techniques, or a combination thereof.

The methods discussed above along with the technologies involved provide an opportunity to recalibrate the 3D numerical models to the best available data. However, it becomes more pertinent to understand the importance of selecting the right candidate wells, for carrying out the acquisition, so that the maximum potential of the methods may be realized. Although the methodology of selecting the right candidate wells may depend on various techno-economic considerations of a field development plan (FDP), certain guidelines can be followed to design the acquisition, to improve the reservoir characterization, as described below.

The methods may be applicable fields in the development phase. One of the plans in a development scenario is drilling infill wells to exploit bypassed/left-over oil pockets. Such planned infill wells, if falling under a favorable aspect ratio with any existing cased well or any other planned infill well, can form a candidate for cross-well acquisition. If multiple such pairs are available, the pair falling in the most heterogenous part of the reservoir may be selected for acquisition. Such a selection may ensure that most of the rock and fluid properties are tuned for the entire reservoir.

A reservoir under pressure maintenance through water flooding, may have several potential areas where new infill production/injection wells may be planned to drill. One possible candidate for the acquisition may be a new infill producer and an existing injector pair with a favorable aspect ratio. Furthermore, if this pair can be identified in the most heterogenous part of the reservoir, it may be an added benefit, as it may help in a better mapping of the water front movement across various heterogenous layers along with characterizing the reservoir facies distribution. For a waterflood scenario, deep look cross-well EM acquisition becomes more suitable, as EM is applicable in cases of resistivity contrast.

In a gas flood scenario, cross-well seismic acquisition technology may be better suited, as the density differences in the in-situ fluids would be prominent and can be mapped seismically. The methods described above may tune the rock/fluid parameters and thus improve the characterization in the full-field and not locally at the candidate wells. So, the acquisition may not be planned to introduce local improvements in characterization.

The foregoing methods scale the cross-well EM results to a full-field level. The process of calibration using evolution strategy may be fully-automated, which makes determining the RMSE quicker and more effective than conventional methods. Use of streamlines technology may enhance the scalability of application to fine grid GCMs, with fast simulation run-times, which may be helpful to quickly calibrate the dynamic models for water saturation. The methods may achieve a better predictive model fit for waterflood surveillance, particularly in aging reservoirs.

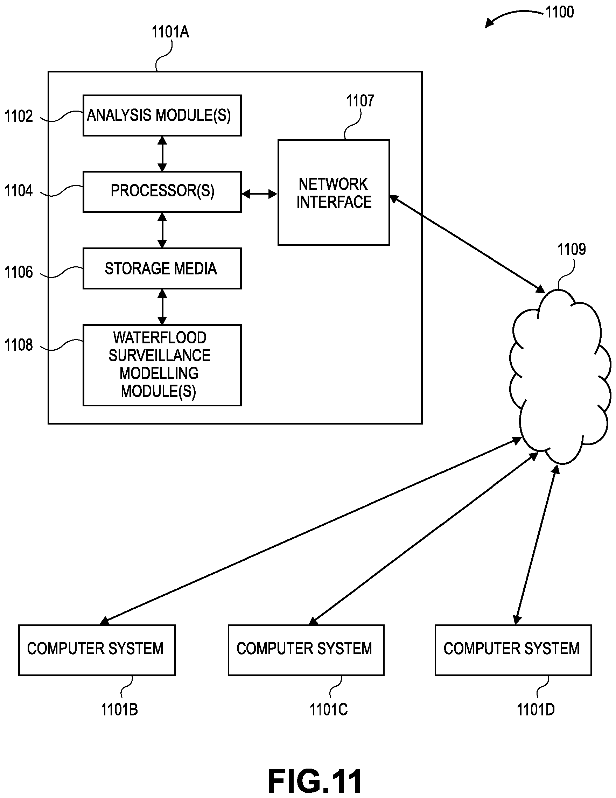

In some embodiments, any of the methods of the present disclosure may be executed by a computing system. Figure 11 illustrates an example of such a computing system 1100, in accordance with some embodiments. The computing system 1100 may include a computer or computer system 1101A, which may be an individual computer system 1101A or an arrangement of distributed computer systems. The computer system 1101A includes one or more analysis module(s) 1102 configured to perform various tasks according to some embodiments, such as one or more methods disclosed herein. To perform these various tasks, the analysis module 1102 executes independently, or in coordination with, one or more processors 1104, which is (or are) connected to one or more storage media 1106. The processor(s) 1104 is (or are) also connected to a network interface 1107 to allow the computer system 1101A to communicate over a data network 1109 with one or more additional computer systems and/or computing systems, such as 1101B, 1101C, and/or 1101D (note that computer systems 1101B, 1101C and/or 1101D may or may not share the same architecture as computer system 1101A, and may be located in different physical locations, e.g., computer systems 1101A and 1101B may be located in a processing facility, while in communication with one or more computer systems such as 1101C and/or 1101D that are located in one or more data centers, and/or located in varying countries on different continents).

A processor can include a microprocessor, microcontroller, processor module or subsystem, programmable integrated circuit, programmable gate array, or another control or computing device.

The storage media 1106 can be implemented as one or more computer-readable or machine-readable storage media. Note that while in the example embodiment of Figure 11 storage media 1106 is depicted as within computer system 1101A, in some embodiments, storage media 1106 may be distributed within and/or across multiple internal and/or external enclosures of computing system 1101A and/or additional computing systems. Storage media 1106 may include one or more different forms of memory including semiconductor memory devices such as dynamic or static random access memories (DRAMs or SRAMs), erasable and programmable read-only memories (EPROMs), electrically erasable and programmable read-only memories (EEPROMs) and flash memories, magnetic disks such as fixed, floppy and removable disks, other magnetic media including tape, optical media such as compact disks (CDs) or digital video disks (DVDs), BLURAY^{®} disks, or other types of optical storage, or other types of storage devices. Note that the instructions discussed above can be provided on one computer-readable or machine-readable storage medium, or alternatively, can be provided on multiple computer-readable or machine-readable storage media distributed in a large system having possibly plural nodes. Such computer-readable or machine-readable storage medium or media is (are) considered to be part of an article (or article of manufacture). An article or article of manufacture can refer to any manufactured single component or multiple components. The storage medium or media can be located either in the machine running the machine-readable instructions, or located at a remote site from which machine-readable instructions can be downloaded over a network for execution.

In some embodiments, computing system 1100 contains one or more waterflood surveillance modeling module(s) 1108 that may perform at least a portion of one or more of the method(s) 400, 900, 1000 described above. It should be appreciated that computing system 1100 is only one example of a computing system, and that computing system 1100 may have more or fewer components than shown, may combine additional components not depicted in the example embodiment of Figure 11, and/or computing system 1100 may have a different configuration or arrangement of the components depicted in Figure 11. The various components shown in Figure 11 may be implemented in hardware, software, or a combination of both hardware and software, including one or more signal processing and/or application specific integrated circuits.

Further, the steps in the processing methods described herein may be implemented by running one or more functional modules in information processing apparatus such as general purpose processors or application specific chips, such as ASICs, FPGAs, PLDs, or other appropriate devices. These modules, combinations of these modules, and/or their combination with general hardware are all included within the scope of protection of the invention.

Geologic interpretations, models and/or other interpretation aids may be refined in an iterative fashion; this concept is applicable to embodiments of the present methods discussed herein. This can include use of feedback loops executed on an algorithmic basis, such as at a computing device (e.g., computing system 1100, Figure 11), and/or through manual control by a user who may make determinations regarding whether a given step, action, template, model, or set of curves has become sufficiently accurate for the evaluation of the subsurface three-dimensional geologic formation under consideration.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings. Moreover, the order in which the elements of the methods are illustrated and described may be re-arranged, and/or two or more elements may occur simultaneously. The embodiments were chosen and described in order to best explain the principals of the invention and its practical applications, to thereby enable others skilled in the art to best utilize the invention and various embodiments with various modifications as are suited to the particular use contemplated. The scope of protection is defined by the appended set of claims.

## Claims

1. A method (400) for modeling a subterranean formation, comprising:
measuring or receiving (402) cross-well electromagnetic data representing a subterranean formation;
producing (404) a resistivity profile of the subterranean formation based at least partially upon the cross-well electromagnetic data;
determining (406) a static model of the subterranean formation based at least partially upon the resistivity profile, wherein the static model comprises a static geo-cellular model and
wherein determining the static model comprises calibrating a porosity (910) in the static model, by reducing an error between the porosity in the static geo-cellular model and a porosity derived from the cross-well electromagnetic data;
determining (408) a dynamic model of the subterranean formation based at least partially upon the static model;
determining (410) whether to waterflood or gasflood the subterranean formation based at least partially upon the static model and/or the dynamic model; and
building or updating a three-dimensional (3D) reservoir model of the subterranean formation for use in operations to waterflood the subterranean formation.

2. The method of claim 1, wherein the resistivity profile is produced using tomographic inversion, and wherein the resistivity profile comprises a two-dimensional section of the subterranean formation between two wells.

3. The method of claim 1, wherein determining the static model comprises determining a porosity (912) in a two-dimensional section of the static model using petrophysical joint inversion based at least partially upon amplitude-versus-offset data seismic inversion, cross-well electromagnetic inversion, or both.

4. The method of claim 1, wherein determining the static model comprises determining a porosity (912) in a two-dimensional section of the static model using a multi-attribute rock physics transform, a stochastic joint porosity saturation inversion, or both based at least partially upon a ratio of primary wave velocity to secondary wave velocity in the subterranean formation, a density of the subterranean formation, or both.

5. The method of claim 1, wherein calibrating the porosity in the static geo-cellular model is an iterative process that produces a plurality of calibrated static geo-cellular models (870), and wherein the dynamic model is determined based at least partially upon one or more of the plurality of calibrated static geo-cellular models (870) with the error below a predetermined threshold (860).

6. The method of claim 1, wherein determining the dynamic model comprises determining a fluid saturation in a two-dimensional section of the dynamic model based at least partially on the resistivity profile.

7. The method of claim 1, wherein the dynamic model comprises a dynamic reservoir model and wherein determining the dynamic model comprises calibrating a fluid saturation in the dynamic model, by reducing an error between the fluid saturation in the dynamic reservoir model and a fluid saturation derived from the cross-well electromagnetic data.

8. The method of claim 1, wherein determining a porosity of the static model and determining a water saturation of the dynamic model reduces an uncertainty in rock parameters and fluid parameters, wherein building or updating a three-dimensional (3D) reservoir model of the subterranean formation is based at least partially upon the rock parameters and the fluid parameters.

9. The method of claim 1, wherein calibrating a porosity comprises:
varying one or more parameters of the static geo-cellular model to reduce a difference between the porosity of the static geo-cellular model and the porosity of the subterranean formation based at least partially upon the resistivity profile, thereby producing a second static geo-cellular model.

10. The method of claim 9, wherein reducing the difference comprises reducing an error between the porosity of the static geo-cellular model and the porosity of the subterranean formation based at least partially upon the resistivity profile and determining whether the error of the static geo-cellular model is below a predetermined threshold.

11. The method of claim 1, wherein determining a static model of the subterranean formation comprises:
determining (1006) a fluid saturation of the subterranean formation based at least partially upon the resistivity profile; and wherein determining a static model of the subterranean formation comprises:
obtaining (1008) a first dynamic reservoir model of the subterranean formation;
determining (1010, 1012) a fluid saturation of the first dynamic reservoir model; and
varying (1014) one or more parameters of the first dynamic reservoir model to reduce a difference between the fluid saturation of the first dynamic reservoir model and the fluid saturation of the subterranean formation based at least partially upon the resistivity profile, thereby producing a second dynamic reservoir model.

12. The method of claim 11, wherein the first dynamic reservoir model is based at least partially upon one or more static geo-cellular models and wherein an error between a porosity of the one or more static geo-cellular models and a porosity based at least partially upon the cross-well electromagnetic data is less than a predetermined threshold (1016).

## Patentansprüche

1. Verfahren (400) zum Modellieren einer unterirdischen Formation, umfassend:
Messen oder Empfangen (402) von bohrlochübergreifenden elektromagnetischen Daten, die eine unterirdische Formation darstellen;
Erzeugen (404) eines Widerstandsprofils der unterirdischen Formation, basierend mindestens teilweise auf den bohrlochübergreifenden elektromagnetischen Daten;
Bestimmen (406) eines statischen Modells der unterirdischen Formation, basierend mindestens teilweise auf dem Widerstandsprofil, wobei das statische Modell ein statisches geozelluläres Modell umfasst und wobei das Bestimmen des statischen Modells ein Kalibrieren einer Porosität (910) in dem statischen Modell durch Reduzieren eines Fehlers zwischen der Porosität in dem statischen geozellulären Modell und einer Porosität, die aus den bohrlochübergreifenden elektromagnetischen Daten abgeleitet wird, umfasst;
Bestimmen (408) eines dynamischen Modells der unterirdischen Formation, basierend mindestens teilweise auf dem statischen Modell;
Bestimmen (410), ob die unterirdische Formation mit Wasser oder Gas geflutet werden soll, basierend mindestens teilweise auf dem statischen Modell und/oder dem dynamischen Modell; und
Erstellen oder Aktualisieren eines dreidimensionalen (3D) Reservoirmodells der unterirdischen Formation zur Verwendung bei Wasserflutungsvorgängen der unterirdischen Formation.

2. Verfahren nach Anspruch 1, wobei das Widerstandsprofil unter Verwendung einer tomographischen Inversion erzeugt wird und wobei das Widerstandsprofil einen zweidimensionalen Abschnitt der unterirdischen Formation zwischen zwei Bohrlöchern umfasst.

3. Verfahren nach Anspruch 1, wobei das Bestimmen des statischen Modells das Bestimmen einer Porosität (912) in einem zweidimensionalen Abschnitt des statischen Modells unter Verwendung einer petrophysikalischen Fugeninversion umfasst, basierend mindestens teilweise auf Amplitude-Versus-Offset-Daten einer seismischen Inversion, einer bohrlochübergreifenden elektromagnetischen Inversion oder beidem.

4. Verfahren nach Anspruch 1, wobei das Bestimmen des statischen Modells das Bestimmen einer Porosität (912) in einem zweidimensionalen Abschnitt des statischen Modells unter Verwendung einer mehrattributiven Gesteinsphysiktransformation, einer stochastischen Fugenporositätssättigungsinversion oder beidem umfasst, basierend mindestens teilweise auf einem Verhältnis einer Primärwellengeschwindigkeit zu einer Sekundärwellengeschwindigkeit in der unterirdischen Formation, einer Dichte der unterirdischen Formation oder beidem.

5. Verfahren nach Anspruch 1, wobei das Kalibrieren der Porosität in dem statischen geozellulären Modell ein iterativer Prozess ist, der eine Vielzahl von kalibrierten statischen geozellulären Modellen (870) erzeugt, und wobei das dynamische Modell mindestens teilweise basierend auf einem oder mehreren der Vielzahl von kalibrierten statischen geozellulären Modellen (870) bestimmt wird, wobei der Fehler unter einem vorgegebenen Schwellenwert (860) liegt.

6. Verfahren nach Anspruch 1, wobei das Bestimmen des dynamischen Modells das Bestimmen einer Flüssigkeitssättigung in einem zweidimensionalen Abschnitt des dynamischen Modells mindestens teilweise basierend auf dem Widerstandsprofil umfasst.

7. Verfahren nach Anspruch 1, wobei das dynamische Modell ein dynamisches Reservoirmodell umfasst und wobei das Bestimmen des dynamischen Modells das Kalibrieren einer Flüssigkeitssättigung in dem dynamischen Modell durch Reduzieren eines Fehlers zwischen der Flüssigkeitssättigung in dem dynamischen Reservoirmodell und einer Flüssigkeitssättigung, die aus den bohrlochübergreifenden elektromagnetischen Daten abgeleitet wird, umfasst.

8. Verfahren nach Anspruch 1, wobei das Bestimmen einer Porosität des statischen Modells und das Bestimmen einer Wassersättigung des dynamischen Modells eine Unsicherheit bei Gesteinsparametern und Flüssigkeitsparametern reduziert, wobei das Erstellen oder Aktualisieren eines dreidimensionalen (3D) Reservoirmodells der unterirdischen Formation mindestens teilweise auf den Gesteinsparametern und den Flüssigkeitsparametern basiert.

9. Verfahren nach Anspruch 1, wobei das Kalibrieren einer Porosität umfasst:
Variieren eines oder mehrerer Parameter des statischen geozellulären Modells, um einen Unterschied zwischen der Porosität des statischen geozellulären Modells und der Porosität der unterirdischen Formation mindestens teilweise basierend auf dem Widerstandsprofil zu reduzieren, wodurch ein zweites statisches geozelluläres Modell erzeugt wird.

10. Verfahren nach Anspruch 9, wobei das Reduzieren des Unterschieds das Reduzieren eines Fehlers zwischen der Porosität des statischen geozellulären Modells und der Porosität der unterirdischen Formation mindestens teilweise basierend auf dem Widerstandsprofil und das Bestimmen, ob der Fehler des statischen geozellulären Modells unter einem vorgegebenen Schwellenwert liegt, umfasst.

11. Verfahren nach Anspruch 1, wobei das Bestimmen eines statischen Modells der unterirdischen Formation umfasst:
Bestimmen (1006) einer Flüssigkeitssättigung der unterirdischen Formation mindestens teilweise basierend auf dem Widerstandsprofil; und
wobei das Bestimmen eines statischen Modells der unterirdischen Formation umfasst:
Erhalten (1008) eines ersten dynamischen Reservoirmodells der unterirdischen Formation;
Bestimmen (1010, 1012) einer Flüssigkeitssättigung des ersten dynamischen Reservoirmodells; und
Variieren (1014) eines oder mehrerer Parameter des ersten dynamischen Reservoirmodells, um einen Unterschied zwischen der Flüssigkeitssättigung des ersten dynamischen Reservoirmodells und der Flüssigkeitssättigung der unterirdischen Formation basierend mindestens teilweise auf dem Widerstandsprofil zu reduzieren, wodurch ein zweites dynamisches Reservoirmodell erzeugt wird.

12. Verfahren nach Anspruch 11, wobei das erste dynamische Reservoirmodell mindestens teilweise auf einem oder mehreren statischen geozellulären Modellen basiert und wobei ein Fehler zwischen einer Porosität des einen oder der mehreren statischen geozellulären Modelle und einer Porosität, basierend mindestens teilweise auf den bohrlochübergreifenden elektromagnetischen Daten, kleiner als ein vorgegebener Schwellenwert (1016) ist.

## Revendications

1. Procédé (400) de modélisation d'une formation souterraine, comprenant :
la mesure ou la réception (402) de données électromagnétiques de puits croisé représentant une formation souterraine ;
la production (404) d'un profil de résistivité de la formation souterraine sur la base, au moins en partie, des données électromagnétiques de puits croisé ;
la détermination (406) d'un modèle statique de la formation souterraine sur la base, au moins en partie, du profil de résistivité, dans lequel le modèle statique comprend un modèle géo-cellulaire statique et dans lequel la détermination du modèle statique comprend l'étalonnage d'une porosité (910) dans le modèle statique, en réduisant une erreur entre la porosité dans le modèle géo-cellulaire statique et une porosité dérivée des données électromagnétiques de puits croisé ;
la détermination (408) d'un modèle dynamique de la formation souterraine sur la base, au moins en partie, du modèle statique ;
le fait de déterminer (410) si la formation souterraine doit être soumise à une injection d'eau ou de gaz sur la base, au moins en partie, du modèle statique et/ou du modèle dynamique ; et
la construction ou la mise à jour d'un modèle de réservoir tridimensionnel (3D) de la formation souterraine pour une utilisation dans des opérations d'injection d'eau dans la formation souterraine.

2. Procédé selon la revendication 1, dans lequel le profil de résistivité est produit à l'aide d'une inversion tomographique, et dans lequel le profil de résistivité comprend une section bidimensionnelle de la formation souterraine entre deux puits.

3. Procédé selon la revendication 1, dans lequel la détermination du modèle statique comprend la détermination d'une porosité (912) dans une section bidimensionnelle du modèle statique à l'aide d'une inversion conjointe pétrophysique sur la base, au moins en partie, d'une inversion sismique de données d'amplitude par rapport au décalage, d'une inversion électromagnétique entre les puits, ou les deux.

4. Procédé selon la revendication 1, dans lequel la détermination du modèle statique comprend la détermination d'une porosité (912) dans une section bidimensionnelle du modèle statique à l'aide d'une transformée de physique de roches multi-attributs, d'une inversion stochastique de saturation de porosité conjointe, ou des deux, sur la base, au moins en partie, d'un rapport entre une vitesse d'ondes primaires et une vitesse d'ondes secondaires dans la formation souterraine, d'une densité de la formation souterraine, ou des deux.

5. Procédé selon la revendication 1, dans lequel l'étalonnage de la porosité dans le modèle géo-cellulaire statique est un processus itératif qui produit une pluralité de modèles géo-cellulaires statiques étalonnés (870), et dans lequel le modèle dynamique est déterminé sur la base, au moins en partie, d'un ou plusieurs de la pluralité de modèles géo-cellulaires statiques étalonnés (870) dont l'erreur est inférieure à un seuil prédéterminé (860).

6. Procédé selon la revendication 1, dans lequel la détermination du modèle dynamique comprend la détermination d'une saturation en fluide dans une section bidimensionnelle du modèle dynamique, sur la base, au moins en partie, du profil de résistivité.

7. Procédé selon la revendication 1, dans lequel le modèle dynamique comprend un modèle de réservoir dynamique et dans lequel la détermination du modèle dynamique comprend l'étalonnage d'une saturation en fluide dans le modèle dynamique, en réduisant une erreur entre la saturation en fluide dans le modèle de réservoir dynamique et une saturation en fluide dérivée des données électromagnétiques de puits croisé.

8. Procédé selon la revendication 1, dans lequel la détermination d'une porosité du modèle statique et la détermination d'une saturation en eau du modèle dynamique réduisent une incertitude des paramètres de roche et des paramètres de fluide, dans lequel la construction ou la mise à jour d'un modèle de réservoir tridimensionnel (3D) de la formation souterraine est basée, au moins en partie, sur les paramètres de roche et les paramètres de fluide.

9. Procédé selon la revendication 1, dans lequel l'étalonnage d'une porosité comprend :
le fait de faire varier un ou plusieurs paramètres du modèle géo-cellulaire statique pour réduire une différence entre la porosité du modèle géo-cellulaire statique et la porosité de la formation souterraine sur la base, au moins en partie, du profil de résistivité, produisant ainsi un second modèle géo-cellulaire statique.

10. Procédé selon la revendication 9, dans lequel la réduction de la différence comprend la réduction d'une erreur entre la porosité du modèle géo-cellulaire statique et la porosité de la formation souterraine sur la base, au moins en partie, du profil de résistivité et le fait de déterminer si l'erreur du modèle géo-cellulaire statique est en dessous d'un seuil prédéterminé.

11. Procédé selon la revendication 1, dans lequel la détermination d'un modèle statique de la formation souterraine comprend :
la détermination (1006) d'une saturation en fluide de la formation souterraine sur la base, au moins en partie, du profil de résistivité ; et
dans lequel la détermination d'un modèle statique de la formation souterraine comprend :
l'obtention (1008) d'un premier modèle de réservoir dynamique de la formation souterraine ;
la détermination (1010, 1012) de la saturation en fluide du premier modèle de réservoir dynamique ; et
le fait de faire varier (1014) un ou plusieurs paramètres du premier modèle de réservoir dynamique pour réduire une différence entre la saturation en fluide du premier modèle de réservoir dynamique et la saturation en fluide de la formation souterraine, sur la base, au moins en partie, du profil de résistivité, produisant ainsi un second modèle de réservoir dynamique.

12. Procédé selon la revendication 11, dans lequel le premier modèle de réservoir dynamique est basé, au moins en partie, sur un ou plusieurs modèles géo-cellulaires statiques et dans lequel une erreur entre une porosité du ou des modèles géo-cellulaires statiques et une porosité basée, au moins en partie, sur les données électromagnétiques de puits croisé est inférieure à un seuil prédéterminé (1016).
